# EUROPEAN PATENT APPLICATION

(11) **EP 3 883 130 A1**
(43) Date of publication of application: **22.09.2021**
(21) Application number: 19884110.8
(22) Date of filing: 29.10.2019
(51) Int. Cl.: H03H 9/25

(54) **BULK ACOUSTIC WAVE RESONATOR, FILTER, AND ELECTRONIC DEVICE**

(30) Priority: 14.11.2018 CN 201811355050
(71) Applicant: Tianjin University, Tianjin 300072 (CN); Rofs Microsystem (Tianjin) Co., Ltd, Tianjin 300462 (CN)
(72) Inventor: ZHANG, Menglun, Tianjin 300072 (CN); PANG, Wei, Tianjin 300072 (CN); SUN, Chen, Tianjin 300072 (CN); YANG, Qingrui, Tianjin 300072 (CN)
(74) Representative: Bandpay & Greuter
(86) International application number: PCT/CN2019/113997
(87) International publication number: WO 2020/098478

(57) **Abstract**

The present invention relates to a bulk acoustic wave resonator, including: a substrate; an acoustic mirror; a bottom electrode arranged above the substrate; a top electrode opposed to the bottom electrode; and a piezoelectric layer arranged above the bottom electrode and between the bottom electrode and the top electrode, wherein at least one of the two ends of the top electrode is provided with a transverse mode vibration suppression structure, and the suppression structure includes a non-parallel structure of upper and lower surfaces arranged on at least one of the two ends of the top electrode. The present invention further relates to a filter having the resonator, and an electronic device having the filter.

## Description

### Field of the Invention

Embodiments of the present invention relate to the field of semiconductors, in particular to a bulk acoustic wave resonator, a filter having the resonator, and an electronic device having the filter.

### Background of the Invention

A film bulk wave resonator made by the longitudinal resonance of a piezoelectric film in the thickness direction has become a feasible alternative to surface acoustic wave devices and quartz crystal resonators in terms of machine communication and high-speed serial data applications. A radio frequency front end bulk wave filter/duplexer provides superior filtering characteristics, such as low insertion loss, steep transition band, higher power capacity, and stronger electrostatic discharge (ESD) resistance. A high-frequency film bulk wave oscillator with ultra-low frequency temperature drift has low phase noise, low power consumption and a large bandwidth modulation range. In addition, these miniature film resonators use CMOS-compatible processing technology on silicon substrates, which can reduce the unit cost and facilitate the final integration with CMOS circuits.

The bulk wave resonator includes an acoustic mirror, two electrodes, and a piezoelectric material layer called piezoelectric excitation between the two electrodes. A bottom electrode and a top electrode are also called excitation electrodes, and their function is to cause mechanical oscillation of each layer of the resonator. An acoustic mirror forms acoustic isolation between the bulk wave resonator and the substrate to prevent acoustic waves from being conducted to the outside of the resonator to cause energy loss.

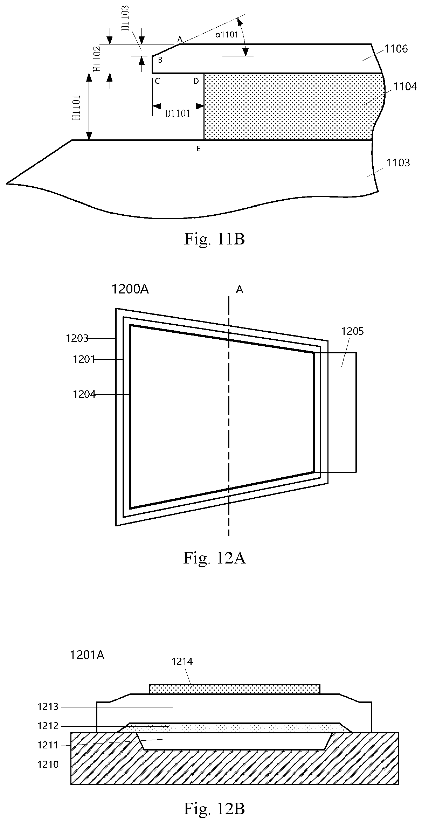

The example 1200A in Fig. 12A is a top view of a traditional bulk acoustic wave resonator. The acoustic mirror 1201 is composed of an air cavity on the substrate, and its function is to approximately convert the acoustic impedance of the substrate into the acoustic impedance of air. Most of the bottom electrode (not shown here) should be located on the inner side of the boundary of the acoustic mirror 1201. The bottom electrode is covered with a piezoelectric film 1203, and the boundary of the piezoelectric film is located on the outer side of the boundary of the acoustic mirror. The piezoelectric layer is covered with a top electrode 1204, and the top electrode has an extended end 1205 at the same time.

The example 1201A in Fig. 12B is a schematic section view of the example 1200A at AA'. The structure includes a substrate 1210, an acoustic mirror 1211, a bottom electrode 1212, a piezoelectric layer 1213 and a top electrode 1214.

In an ideal state, the energy of an alternating electrical signal applied to the top electrode and the bottom electrode is only converted into the acoustic energy of a longitudinal vibration mode (usually called a piston mode) of the piezoelectric layer. In actual situations, along with the longitudinal vibration mode, acoustic waves in a transverse vibration mode are also generated, the existence of the waves in the transverse vibration mode will weaken the energy of the acoustic waves in the piston mode, thereby resulting in serious deterioration in the key performance parameters of the device such as quality factor (Q) and effective electromechanical coupling factor (*K²_{t,eff}*)*.* At the same time, the filter constructed by the bulk acoustic wave resonator also generates noise on a filter frequency characteristic curve, thereby reducing the performance of the filter system.

Generally, the transverse mode is parasitic in the entire space formed by the upper bottom electrode and the piezoelectric layer. Especially when the geometrical shape of the cross section of the film layer has parallel sides in pairs, the transverse mode will be enhanced because of the formation of standing waves.

In the example 1201A of the traditional bulk acoustic wave resonator, the top electrode has a rectangular cross section structure, the structure is suitable for acoustic waves in the parasitic mode to form stable standing waves therein, so that the acoustic waves in the parasitic mode occupy considerable energy, which seriously affects the performance of the resonator. Therefore, the structure of the top electrode structure needs to be improved to improve the performance of the resonator.

### Summary of the Invention

In order to suppress or further reduce the parasitism of acoustic waves in a transverse mode in the top electrode structure in a bulk acoustic wave resonator, the present invention is proposed.

According to one aspect of an embodiment of the present invention, a bulk acoustic wave resonator is proposed, including: a substrate; an acoustic mirror; a bottom electrode arranged above the substrate; a top electrode opposed to the bottom electrode; and a piezoelectric layer arranged above the bottom electrode and between the bottom electrode and the top electrode, wherein at least one of the two ends of the top electrode is provided with a transverse mode vibration suppression structure.

Optionally, the suppression structure includes a non-parallel structure of upper and lower surfaces arranged on at least one of the two ends of the top electrode.

Optionally, at least a part of at least one of the upper and lower surfaces of at least one end of the top electrode is an inclined surface.

Further, the angle formed by the inclined surface and the surface of the substrate is 15-75 degrees.

Further, the length of the inclined surface in the horizontal direction ranges from 0.02µm to 3µm.

Or further, at least one of the upper and lower surfaces of at least one end of the top electrode includes: a vertical extension surface and/or a horizontal extension surface; and the inclined surface.

Optionally, the suppression structure includes a non-vertical surface that is arranged at the end face of at least one end of the top electrode and is different from a vertical surface, wherein the vertical surface is perpendicular to the surface of the substrate. Further optionally, the non-vertical surface has a shape of a concave surface or a convex surface.

Optionally, the above-mentioned resonator further includes a passivation layer arranged on the top electrode. Further, the thickness of the passivation layer is 0.01µm to 0. 1um.

Optionally, the above-mentioned resonator further includes a metal electrode material layer and a passivation layer, which are sequentially arranged on the top electrode. Further, the thickness of the metal electrode material layer is 0.04µm to 0.24µm.

Optionally, at least one end part of the top electrode comprises a suspension wing structure, and the suspension wing structure includes the suppression structure.

Optionally, the two ends of the top electrode are axisymmetric structures to each other.

Optionally, the resonator further includes a passivation layer, and the passivation layer is disposed to cover the top electrode, wherein: at least one end of the passivation layer extends beyond the corresponding end of the top electrode; and the end of the passivation layer extending beyond the corresponding end of the top electrode is provided with the suppression structure.

Optionally, the suppression structure includes a non-parallel structure of upper and lower surfaces of the passivation layer; and/or the suppression structure includes a non-vertical structure that is arranged at the end face of at least one end of the passivation layer and is different from the vertical surface, wherein the vertical surface is perpendicular to the surface of the substrate.

Optionally, at least one end part of the top electrode comprises a suspension wing structure.

Optionally, the two ends of the passivation layer extend beyond the corresponding end parts of the top electrode and are axisymmetric structures to each other.

Optionally, the distance of the end part of the passivation layer extending beyond the top electrode is 0.1µm to 3µm.

Optionally, the thickness of the passivation layer is 0.04µm to 0.24µm.

The embodiment of the present invention further relates to a filter, including the above-mentioned bulk acoustic wave resonator.

The embodiment of the present invention further relates to an electronic device, including the above-mentioned filter.

### Brief Description of the Drawings

The following descriptions and drawings can better help understand these and other features and advantages in various embodiments disclosed in the present invention. The same reference signs in the drawings always indicate the same components, wherein:
Fig. 1A is a schematic section view of a bulk acoustic wave resonator according to an exemplary embodiment of the present invention;
Fig. 1B is an enlarged view of a detail part in Fig. 1A;
Fig. 1C is an enlarged view of adding a passivation layer on the basis of the structure of Fig. 1B;
Fig. 1D is an enlarged view of adding a passivation layer and a metal electrode material layer on the basis of the structure of Fig. 1B;
Fig. 2A is a schematic section view of a bulk acoustic wave resonator according to an exemplary embodiment of the present invention;
Fig. 2B is an enlarged view of a detail part in Fig. 2A;
Fig. 2C is an enlarged view of adding a passivation layer on the basis of the structure of FIG. 2B;
Fig. 2D is an enlarged view of adding a passivation layer and a metal electrode material layer on the basis of the structure of Fig. 2B;
Fig. 3A is a schematic section view of a bulk acoustic wave resonator according to an exemplary embodiment of the present invention;
Fig. 3B is an enlarged view of a detail part in Fig. 3A;
Fig. 3C is an enlarged view of adding a passivation layer on the basis of the structure of Fig. 3B;
Fig. 3D is an enlarged view of adding a passivation layer and a metal electrode material layer on the basis of the structure of Fig. 3B;
Fig. 4A is a schematic section view of a bulk acoustic wave resonator according to an exemplary embodiment of the present invention;
Fig. 4B is an enlarged view of a detail part in Fig. 4A;
Fig. 4C is an enlarged view of adding a passivation layer on the basis of the structure of Fig. 4B;
Fig. 4D is an enlarged view of adding a passivation layer and a metal electrode material layer on the basis of the structure of Fig. 4B;
Fig. 5A is a schematic section view of a bulk acoustic wave resonator according to an exemplary embodiment of the present invention;
Fig. 5B is an enlarged view of a detail part in Fig. 5A;
Fig. 5C is an enlarged view of adding a passivation layer on the basis of the structure of Fig. 5B;
Fig. 5D is an enlarged view of adding a passivation layer and a metal electrode material layer on the basis of the structure of Fig. 5B;
Fig. 6A is a schematic section view of a bulk acoustic wave resonator according to an exemplary embodiment of the present invention;
Fig. 6B is an enlarged view of a detail part in Fig. 6A;
Fig. 6C is an enlarged view of adding a passivation layer on the basis of the structure of Fig. 6B;
Fig. 6D is an enlarged view of adding a passivation layer and a metal electrode material layer on the basis of the structure of Fig. 6B;
Fig. 7A is a schematic section view of a bulk acoustic wave resonator according to an exemplary embodiment of the present invention;
Fig. 7B is an enlarged view of a detail part in Fig. 7A;
Fig. 7C is an enlarged view of adding a passivation layer on the basis of the structure of Fig. 7B;
Fig. 7D is an enlarged view of adding a passivation layer and a metal electrode material layer on the basis of the structure of Fig. 7B;
Fig. 8A is a schematic section view of a bulk acoustic wave resonator according to an exemplary embodiment of the present invention;
Fig. 8B is an enlarged view of a detail part in Fig. 8A;
Fig. 8C is an enlarged view of adding a passivation layer on the basis of the structure of Fig. 8B;
Fig. 8D is an enlarged view of adding a passivation layer and a metal electrode material layer on the basis of the structure of Fig. 8B;
Fig. 9A is a schematic section view of a bulk acoustic wave resonator according to an exemplary embodiment of the present invention;
Fig. 9B is an enlarged view of a detail part in Fig. 9A;
Fig. 9C is an enlarged view of adding a passivation layer on the basis of the structure of Fig. 9B;
Fig. 9D is an enlarged view of adding a passivation layer and a metal electrode material layer on the basis of the structure of Fig. 9B;
Fig. 10A is a schematic section view of a bulk acoustic wave resonator according to an exemplary embodiment of the present invention;
Fig. 10B is an enlarged view of a detail part in Fig. 10A;
Fig. 10C is an enlarged view of adding a passivation layer on the basis of the structure of Fig. 10B;
Fig. 10D is an enlarged view of adding a passivation layer and a metal electrode material layer on the basis of the structure of Fig. 10B;
Fig. 11A is a schematic section view of a bulk acoustic wave resonator according to an exemplary embodiment of the present invention;
Fig. 11B is an enlarged view of a detail part in Fig. 11A;
Fig. 12A is a schematic top view of a bulk acoustic wave resonator in the prior art;
Fig. 12B is a schematic section view cut along the line AA' in Fig. 12A.

### Detailed Description of the Embodiments

The technical solutions of the present invention will be further described below in detail through the embodiments and in conjunction with the drawings. In the specification, the same or similar reference signs indicate the same or similar components. The following description of the embodiments of the present invention with reference to the drawings is intended to explain the general inventive concept of the present invention, and should not be construed as a limitation to the present invention.

Since the transverse vibration mode usually forms stable standing waves between parallel sides in pairs, a detail structure is arranged at the end part of a top electrode of a bulk acoustic wave resonator in the present invention, for example, this kind of detail structure can effectively eliminate or reduce the parallelism of the opposite sides, and destroy the condition or geometric structure of the transverse acoustic vibration mode to form the standing waves in the top electrode, thereby effectively suppressing the parasitic transverse mode vibration in the top electrode, so that more transverse mode vibration energy can be converted into useful piston mode vibration energy, and the Q value of the resonator is improved as a result.

In the present invention, a dispersion curve near the resonance frequency is optimized by introducing different materials to from a composite top electrode, and at the same time, the resistance of the metal material of the top electrode to the penetration of oxygen and other impurity elements is improved, therefore the Q value and the electromechanical coupling coefficient of the resonator are further improved.

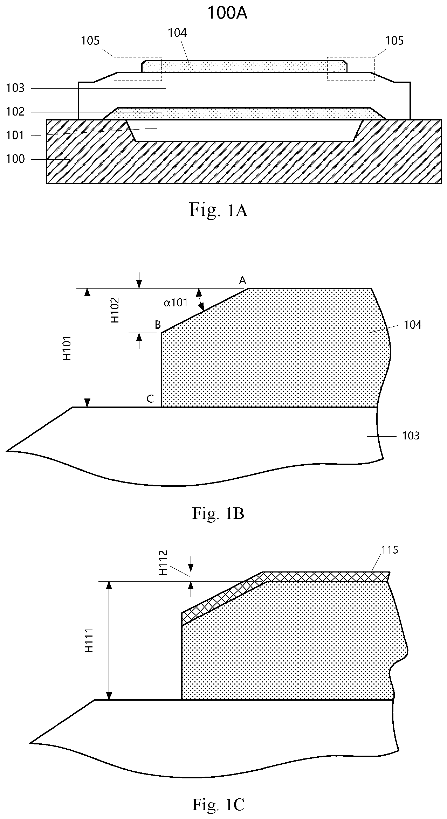

Hereinafter, a bulk acoustic wave resonator according to an embodiment of the present invention will be described with reference to Figs. 1A-11B.

Fig. 1A is a schematic section view of a bulk acoustic wave resonator according to an exemplary embodiment of the present invention. As shown in Fig. 1A, the bulk acoustic wave resonator includes a substrate 100, and an air cavity 101 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 100A further includes a bottom electrode 102, a piezoelectric layer 103 and a top electrode 104. The two ends of the bottom electrode 102 extend beyond the range of the air cavity 101 in two opposite directions, so that the two ends of the trapezoidal lower bottom edge of 102 both have parts that are partially in contact with the upper surface of the substrate 100.

The piezoelectric layer 103 has a stepped structure, which is composed of a first step, a second step and an interface between the two steps, wherein the plane of the first step is higher than the plane of the second step. The first step and the interface form a first edge of the piezoelectric layer; and the second step and the interface form a second edge of the piezoelectric layer.

It should be pointed out that in the present invention, the piezoelectric layer may not have the stepped structure.

The main part of the top electrode 104 completely falls within the range of the first step of the piezoelectric layer in the section view, and the top electrode has an axisymmetric detail structure at its two ends 105 at the same time.

Fig. 1B is an enlarged view of the detail part 105 in Fig. 1A. The top electrode 104 is made of Mo in the present embodiment and has a thickness H101, and the range of H101 is 0.1µm to 0.6µm. The height of an inclined edge AB in the vertical direction is H102, and the range of H102 is 0µm to 0.6µm. The inclined edge AB forms an angle α101 with the horizontal direction, and the range of α101 is 15° to 75°. In the embodiment of the present invention, B and C can also overlap.

In order to prevent the top electrode from being corroded by oxygen and water vapor in the air, a passivation layer 115 is added in Fig. 1C on the basis of Fig. 1B, wherein the material of the passivation layer in the present embodiment can be SiO₂, the thickness of the passivation layer 115 is H112, and range of H112 is 0.02µm to 0.3µm.

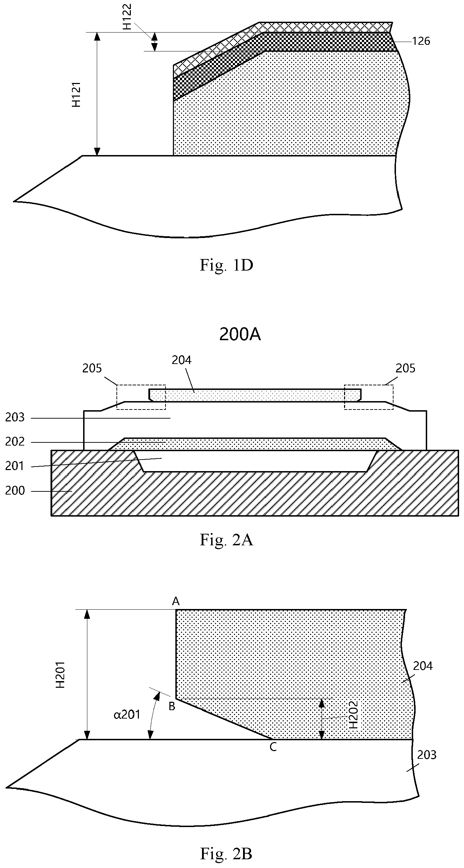

In order to further improve the dispersion curve of the resonator near the series resonance frequency and/or prevent, for example, the oxygen element in the silicon dioxide passivation layer from diffusing to the top electrode layer, a passivation layer is added in Fig. 1D on the basis of Fig. 1B, and at the same time, another layer of metal electrode material 126 is added between the passivation layer and the top electrode. In the present embodiment, this layer of metal material can be chromium (Cr), the thickness of the metal layer 126 is H122, and the range of H122 is 0.04µm to 0.24µm.

Fig. 2A is a schematic section view of a bulk acoustic wave resonator according to an exemplary embodiment of the present invention. As shown in Fig. 2A, the bulk acoustic wave resonator includes a substrate 200, and an air cavity 201 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 200A further includes a bottom electrode 202, a piezoelectric layer 203 and a top electrode 204. The two ends of the bottom electrode 202 extend beyond the range of the air cavity 201 in two opposite directions, so that the two ends of the trapezoidal lower bottom edge of 202 are partially in contact with the upper surface of the substrate 200.

The piezoelectric layer 203 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 204 completely falls within the range of the first step of the piezoelectric layer in the section view, and the top electrode has an axisymmetric detail structure at its two ends 205 at the same time.

Fig. 2B is an enlarged view of a detail part 205 in Fig. 2A, wherein the top electrode 204 is made of Mo in the present embodiment and has a thickness H201, and the range of H201 is 0.1µm to 0.6µm. The height of an inclined edge BC in the vertical direction is H202, and the range of H202 is 0µm to 0.6µm. The inclined edge BC forms an angle α201 with the horizontal direction, and the range of α201 is 15° to 75°.

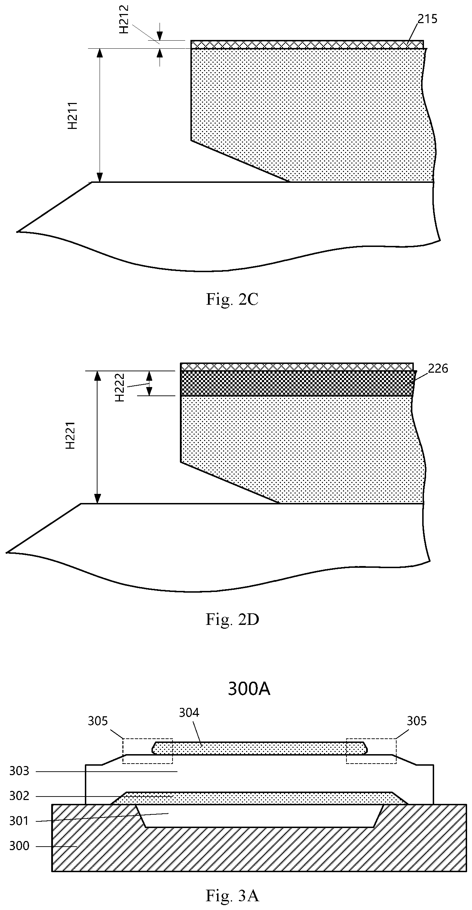

In order to prevent the top electrode from being corroded by oxygen and water vapor in the air, a passivation layer 215 is added in Fig. 2C on the basis of Fig. 2B, wherein the material of the passivation layer in the present embodiment can be SiO₂, the thickness of the passivation layer 215 is H212, and range of H212 is 0.01µm to 0.1µm.

In order to further improve the dispersion curve of the resonator near the series resonance frequency and prevent the oxygen element in the silicon dioxide passivation layer from diffusing to the top electrode layer, a passivation layer is added in Fig. 2D on the basis of Fig. 2B, and at the same time, another layer of metal electrode material 226 is added between the passivation layer and the top electrode. In the present embodiment, this layer of metal material can be chromium (Cr), the thickness of the metal layer 226 is H222, and the range of H222 is 0.04µm to 0.24µm.

Fig. 3A is a schematic section view of a bulk acoustic wave resonator according to an exemplary embodiment of the present invention. As shown in Fig. 3A, the bulk acoustic wave resonator includes a substrate 300, and an air cavity 301 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 300A further includes a bottom electrode 302, a piezoelectric layer 303 and a top electrode 304. The two ends of the bottom electrode 302 extend beyond the range of the air cavity 301 in two opposite directions, so that the two ends of the trapezoidal lower bottom edge of 302 are partially in contact with the upper surface of the substrate 300.

The piezoelectric layer 303 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 304 completely falls within the range of the first step of the piezoelectric layer in the section view, and the top electrode has an axisymmetric detail structure at its two ends 305 at the same time.

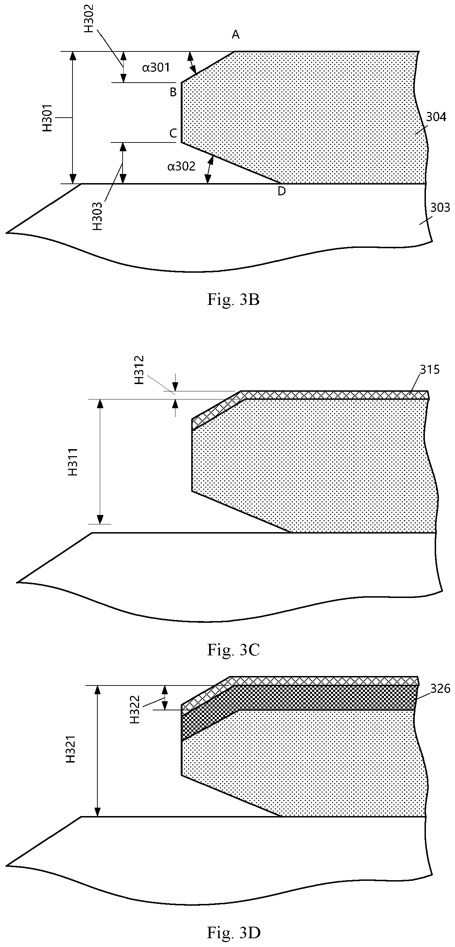

Fig. 3B is an enlarged view of a detail part 305 in Fig. 3A. The top electrode 304 is made of Mo in the present embodiment and has a thickness H301, and the range of H301 is 0. 1µm to 0.6µm. The height of an inclined edge AB in the vertical direction is H302, and the range of H302 is 0µm to 0.6µm. The inclined edge AB forms an angle α301 with the horizontal direction, and the range of α301 is 15° to 75°. The height of an inclined edge CD in the vertical direction is H303, and the range of H303 is 0µm to 0.6µm. The inclined edge CD forms an angle α302 with the horizontal direction, and the range of α302 is 15° to 75°.

In order to prevent the top electrode from being corroded by oxygen and water vapor in the air, a passivation layer 315 is added in Fig. 3C on the basis of Fig. 3B, wherein the material of the passivation layer in the present embodiment can be SiO₂, the thickness of the passivation layer 315 is H312, and range of H312 is 0.01µm to 0.1µm.

In order to further improve the dispersion curve of the resonator near the series resonance frequency and prevent the oxygen element in the silicon dioxide passivation layer from diffusing to the top electrode layer, a passivation layer is added in Fig. 3D on the basis of Fig. 3B, and at the same time, another layer of metal electrode material 326 is added between the passivation layer and the top electrode. In the present embodiment, this layer of metal material can be chromium (Cr), the thickness of the metal layer 326 is H322, and the range of H322 is 0.04µm to 0.24µm.

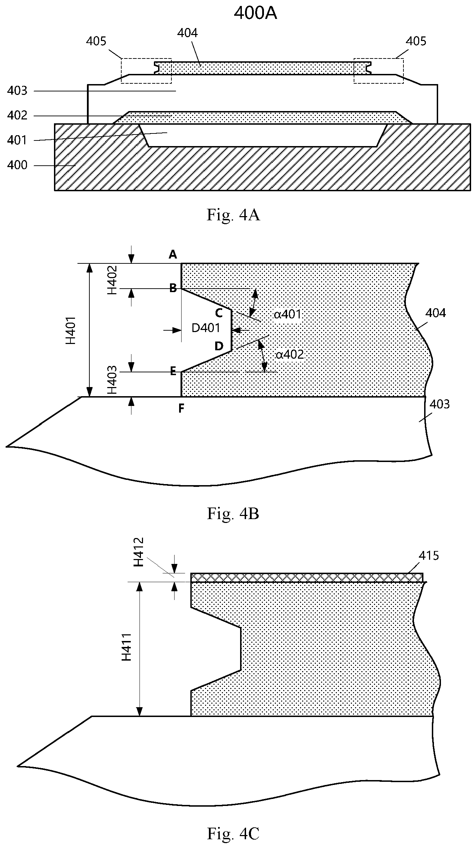

Fig. 4A is a schematic section view of a bulk acoustic wave resonator according to an exemplary embodiment of the present invention. As shown in Fig. 4A, the bulk acoustic wave resonator includes a substrate 400, and an air cavity 401 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 400A further includes a bottom electrode 402, a piezoelectric layer 403 and a top electrode 404. The two ends of the bottom electrode 402 extend beyond the range of the air cavity 401 in two opposite directions, so that the two ends of the trapezoidal lower bottom edge of 402 are partially in contact with the upper surface of the substrate 400.

The piezoelectric layer 403 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 404 completely falls within the range of the first step of the piezoelectric layer in the section view, and the top electrode has an axisymmetric detail structure at its two ends 405 at the same time.

Fig. 4B is an enlarged view of a detail part 405 in Fig. 4A. The top electrode 404 is made of Mo in the present embodiment and has a thickness H401, and the range of H401 is 0. 1µm to 0.6µm. The height of a vertical edge AB is H402, and the range of H402 is 0µm to 0.6µm. An inclined edge BC forms an angle α401 with the horizontal direction, and the range of α401 is 15° to 75°. The horizontal distance between a vertical edge AF and a vertical edge CD is D401, and the range of D401 is 0µm to 1µm. An inclined edge DE forms an angle α402 with the horizontal direction, and the range of α402 is 15° to 75°. The height of a vertical edge EF is H403, and the range of H403 is 0µm to 0.6µm.

In order to prevent the top electrode from being corroded by oxygen and water vapor in the air, a passivation layer 415 is added in Fig. 4C on the basis of Fig. 4B, wherein the material of the passivation layer in the present embodiment can be SiO₂, the thickness of the passivation layer 415 is H412, and range of H412 is 0.01µm to 0.1µm.

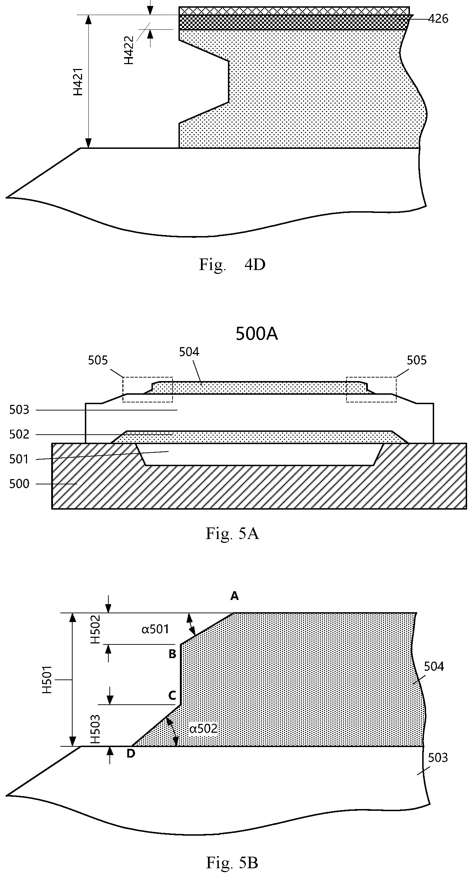

In order to further improve the dispersion curve of the resonator near the series resonance frequency and prevent the oxygen element in the silicon dioxide passivation layer from diffusing to the top electrode layer, a passivation layer is added in Fig. 4D on the basis of Fig. 4B, and at the same time, another layer of metal electrode material 426 is added between the passivation layer and the top electrode. In the present embodiment, this layer of metal material can be chromium (Cr), the thickness of the metal layer 426 is H422, and the range of H422 is 0.04µm to 0.24µm.

Fig. 5A is a schematic section view of a bulk acoustic wave resonator according to an exemplary embodiment of the present invention. As shown in Fig. 5A, the bulk acoustic wave resonator includes a substrate 500, and an air cavity 501 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 500A further includes a bottom electrode 502, a piezoelectric layer 503 and a top electrode 504. The two ends of the bottom electrode 502 extend beyond the range of the air cavity 501 in two opposite directions, so that the two ends of the trapezoidal lower bottom edge of the bottom electrode 502 are partially in contact with the upper surface of the substrate 500.

The piezoelectric layer 503 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 504 completely falls within the range of the first step of the piezoelectric layer in the section view, and the top electrode has an axisymmetric detail structure at its two ends 505 at the same time.

Fig. 5B is an enlarged view of a detail part 505 in Fig. 5A. The top electrode 504 is made of Mo in the present embodiment and has a thickness H501, and the range of H501 is 0. 1µm to 0.6µm. The height of an inclined edge AB is H502, the range of H502 is 0µm to 0.6µm, the inclined edge AB forms an angle α501 with the horizontal direction, and the range of α501 is 15° to 75°. The height of an inclined edge CD is H503, and the range of H503 is 0µm to 0.6µm. The inclined edge CD forms an angle α502 with the horizontal direction, and the range of α502 is 15° to 75°.

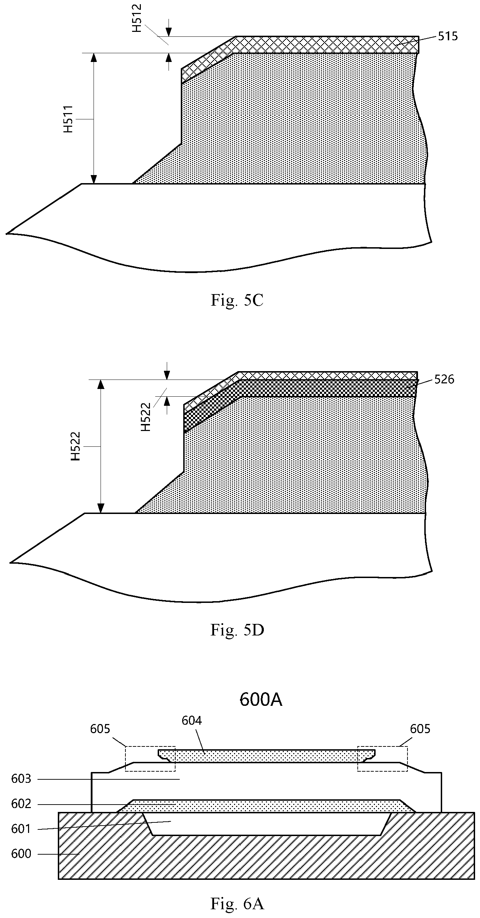

In order to prevent the top electrode from being corroded by oxygen and water vapor in the air, a passivation layer 515 is added in Fig. 5C on the basis of Fig. 5B, wherein the material of the passivation layer in the present embodiment can be SiO₂, the thickness of the passivation layer 515 is H512, and range of H512 is 0.01µm to 0.1µm.

In order to further improve the dispersion curve of the resonator near the series resonance frequency and prevent the oxygen element in the silicon dioxide passivation layer from diffusing to the top electrode layer, a passivation layer is added in Fig. 5D on the basis of Fig. 5B, and at the same time, another layer of metal electrode material 526 is added between the passivation layer and the top electrode. In the present embodiment, this layer of metal material can be chromium (Cr), the thickness of the metal layer 526 is H522, and the range of H522 is 0.04µm to 0.24µm.

Fig. 6A is a schematic section view of a bulk acoustic wave resonator according to an exemplary embodiment of the present invention. As shown in Fig. 6A, the bulk acoustic wave resonator includes a substrate 600, and an air cavity 601 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 600A further includes a bottom electrode 602, a piezoelectric layer 603 and a top electrode 604. The two ends of the bottom electrode 602 extend beyond the range of the air cavity 601 in two opposite directions, so that the two ends of the trapezoidal lower bottom edge of the bottom electrode 602 are partially in contact with the upper surface of the substrate 600.

The piezoelectric layer 603 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 604 completely falls within the range of the first step of the piezoelectric layer in the section view, and the top electrode has an axisymmetric detail structure at its two ends 605 at the same time.

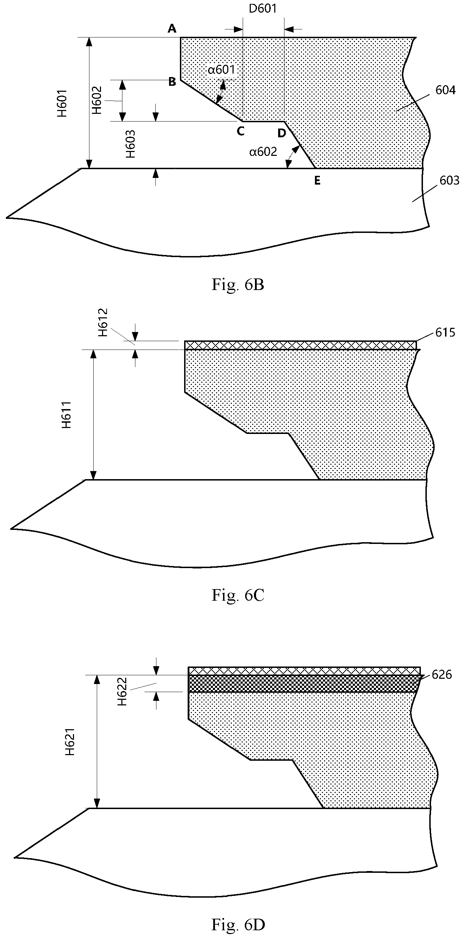

Fig. 6B is an enlarged view of a detail part 605 in Fig. 6A. The top electrode 604 is made of Mo in the present embodiment and has a thickness H601, and the range of H601 is 0. 1µm to 0.6µm. The height of an inclined edge BC is H602, the range of H602 is 0µm to 0.6µm, the inclined edge BC forms an angle α601 with the horizontal direction, and the range of α601 is 15° to 75°. The transverse length of a horizontal edge CD is D601, and the range of D601 is 0µm to 2µm. The height of an inclined edge DE is H603, and the range of H603 is 0µm to 0.6µm. The inclined edge DE forms an angle α602 with the horizontal direction, and the range of α602 is 15° to 75°.

In order to prevent the top electrode from being corroded by oxygen and water vapor in the air, a passivation layer 615 is added in Fig. 6C on the basis of Fig. 6B, wherein the material of the passivation layer in the present embodiment can be SiO₂, the thickness of the passivation layer 615 is H612, and range of H612 is 0.01µm to 0.1µm.

In order to further improve the dispersion curve of the resonator near the series resonance frequency and prevent the oxygen element in the silicon dioxide passivation layer from diffusing to the top electrode layer, a passivation layer is added in Fig. 6D on the basis of Fig. 6B, and at the same time, another layer of metal electrode material 626 is added between the passivation layer and the top electrode. In the present embodiment, this layer of metal material can be chromium (Cr), the thickness of the metal layer 626 is H622, and the range of H622 is 0.04µm to 0.24µm.

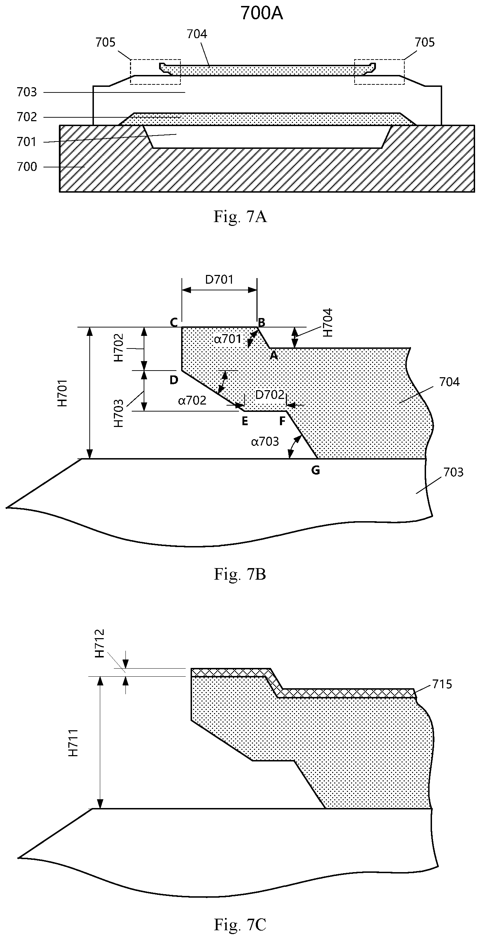

Fig. 7A is a schematic section view of a bulk acoustic wave resonator according to an exemplary embodiment of the present invention. As shown in Fig. 7A, the bulk acoustic wave resonator includes a substrate 700, and an air cavity 701 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 700A further includes a bottom electrode 702, a piezoelectric layer 703 and a top electrode 704. The two ends of the bottom electrode 702 extend beyond the range of the air cavity 701 in two opposite directions, so that the two ends of the trapezoidal lower bottom edge of 702 are partially in contact with the upper surface of the substrate 700.

The piezoelectric layer 703 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 704 completely falls within the range of the first step of the piezoelectric layer in the section view, and the top electrode has an axisymmetric detail structure at its two ends 705 at the same time.

Fig. 7B is an enlarged view of a detail part 705 in Fig. 7A. The top electrode 704 is made of Mo in the present embodiment and has a thickness H701, and the range of H701 is 0. 1µm to 0.6µm. The height of a vertical edge CD is H702, and the range of H702 is 0µm to 0.6µm. The height of an inclined edge DE is H703, the range of H703 is 0µm to 0.6µm, the inclined edge DE forms an angle α702 with the horizontal direction, and the range of α702 is 15° to 75°. The transverse length of a horizontal edge EF is D702, and the range of D702 is 0µm to 2µm. An inclined edge FG forms an angle α703 with the horizontal direction, and the range of α703 is 15° to 75°. The length of a horizontal edge BC in the horizontal direction is D701, and the range of D701 is 0µm to 3µm. The height of an inclined edge AB is H704, and the range of H704 is 0µm to 0.5µm. The inclined edge AB forms an angle α701 with the horizontal direction, and the range of α701 is 15° to 75°.

In order to prevent the top electrode from being corroded by oxygen and water vapor in the air, a passivation layer 715 is added in Fig. 7C on the basis of Fig. 7B, wherein the material of the passivation layer in the present embodiment can be SiO₂, the thickness of the passivation layer 715 is H712, and range of H712 is 0.01µm to 0.1µm.

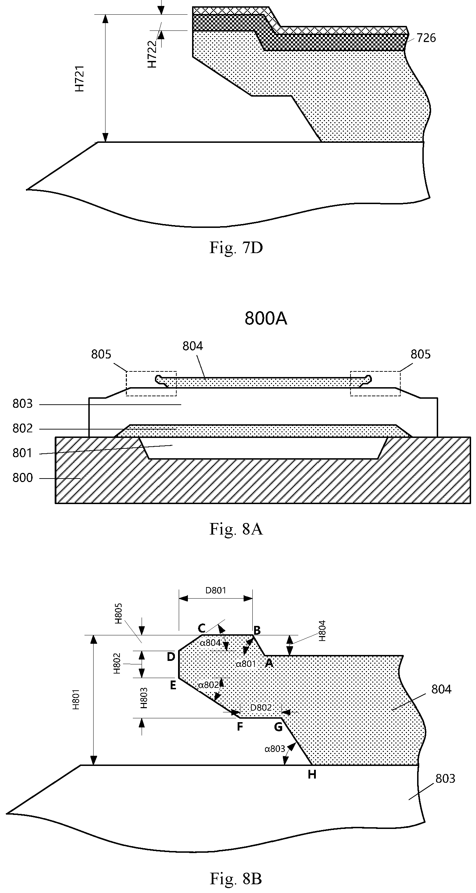

In order to further improve the dispersion curve of the resonator near the series resonance frequency and prevent the oxygen element in the silicon dioxide passivation layer from diffusing to the top electrode layer, a passivation layer is added in Fig. 7D on the basis of Fig. 7B, and at the same time, another layer of metal electrode material 726 is added between the passivation layer and the top electrode. In the present embodiment, this layer of metal material can be chromium (Cr), the thickness of the metal layer 726 is H722, and the range of H722 is 0.04µm to 0.24µm.

Fig. 8A is a schematic section view of a bulk acoustic wave resonator according to an exemplary embodiment of the present invention. As shown in Fig. 8A, the bulk acoustic wave resonator includes a substrate 800, and an air cavity 801 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 800A further includes a bottom electrode 802, a piezoelectric layer 803 and a top electrode 804. The two ends of the bottom electrode 802 extend beyond the range of the air cavity 801 in two opposite directions, so that the two ends of the trapezoidal lower bottom edge of 802 are partially in contact with the upper surface of the substrate 800.

The piezoelectric layer 803 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 804 completely falls within the range of the first step of the piezoelectric layer in the section view, and the top electrode has an axisymmetric detail structure at its two ends 805 at the same time.

Fig. 8B is an enlarged view of a detail part 705 in Fig. 8A. The top electrode 804 is made of Mo in the present embodiment and has a thickness H801, and the range of H801 is 0. 1µm to 0.6µm. The height of an inclined edge CD is H805, and the range of H805 is 0µm to 0.6µm. The inclined edge CD forms an angle α804 with the horizontal direction, and the range of α804 is 15° to 75°. The height of a vertical edge DE is H802, and the range of H802 is 0µm to 0.6µm. The height of an inclined edge EF is H803, and the range of H803 is 0µm to 0.6µm. The inclined edge EF forms an angle α802 with the horizontal direction, and the range of α802 is 15° to 75°. The length of a horizontal edge FG in the horizontal direction is D802, and the range of D802 is 0µm to 1µm. An inclined edge GH forms an angle α803 with the horizontal direction, and the range of α803 is 15° to 75°. The horizontal distance from a point B to the vertical edge DE is D801, and the range of D801 is 0µm to 2µm. The height of an inclined edge AB is H804, and the range of H804 is 0µm to 0 5µm. The inclined edge AB forms an angle α801 with the horizontal direction, and the range of α801 is 15° to 75°.

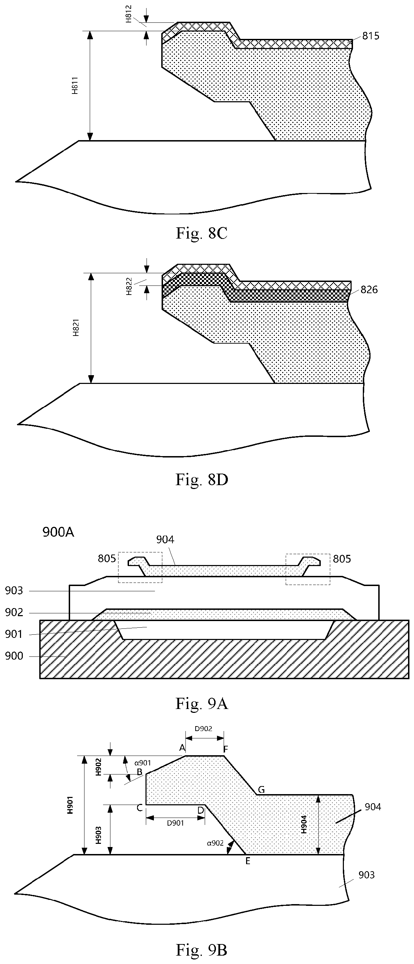

In order to prevent the top electrode from being corroded by oxygen and water vapor in the air, a passivation layer 815 is added in Fig. 8C on the basis of Fig. 8B, wherein the material of the passivation layer in the present embodiment can be SiO₂, the thickness of the passivation layer 815 is H812, and range of H812 is 0.01µm to 0.1µm.

In order to further improve the dispersion curve of the resonator near the series resonance frequency and prevent the oxygen element in the silicon dioxide passivation layer from diffusing to the top electrode layer, a passivation layer is added in Fig. 8D on the basis of Fig. 8B, and at the same time, another layer of metal electrode material 826 is added between the passivation layer and the top electrode. In the present embodiment, this layer of metal material can be chromium (Cr), the thickness of the metal layer 826 is H822, and the range of H822 is 0.04µm to 0.24µm.

Fig. 9A is a schematic section view of a bulk acoustic wave resonator according to an exemplary embodiment of the present invention. As shown in Fig. 9A, the bulk acoustic wave resonator includes a substrate 900, and an air cavity 901 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 900A further includes a bottom electrode 902, a piezoelectric layer 903 and a top electrode 904. The two ends of the bottom electrode 902 extend beyond the range of the air cavity 901 in two opposite directions, so that the two ends of the trapezoidal lower bottom edge of 902 are partially in contact with the upper surface of the substrate 900.

The piezoelectric layer 903 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 904 completely falls within the range of the first step of the piezoelectric layer in the section view, and the top electrode has an axisymmetric detail structure at its two ends 905 at the same time.

Fig. 9B is an enlarged view of a detail part 905 in Fig. 9A. The top electrode 904 is made of Mo in the present embodiment and has a thickness H901, and the range of H901 is 0. 1µm to 0.6µm. The height of an inclined edge AB is H902, and the range of H902 is 0µm to 0.4µm. The inclined edge AB forms an angle α901 with the horizontal direction, and the range of α901 is 15° to 75°. The length of a horizontal edge CD is D901, and the range of D901 is 0µm to 2µm. The height of an inclined edge DE is H903, and the range of H903 is 0.2µm to 0.6µm. DE forms an included angle α902 with the horizontal direction, and the range of α902 is 15° to 75°. The height of a horizontal edge AF is D902, and the range of D902 is 0µm to 2µm. An inclined edge FG is parallel to DE. The vertical height from a point G to a point E is H904, and the range of H904 is 0. 1µm to 0.6µm. In the present embodiment, the structure of the end face ABC adopts the structure of the solutions in Fig.1A to Fig.1B, and this is only an example and is not used to limit the use possibilities of the other solutions involved in the specification.

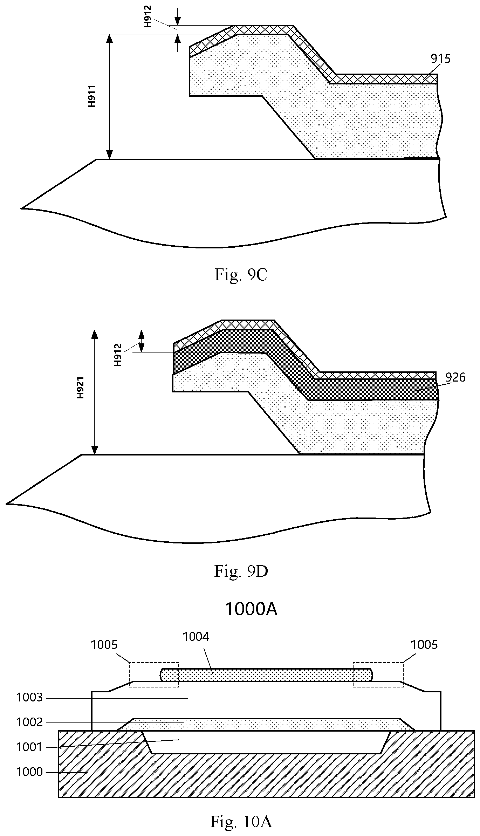

In order to prevent the top electrode from being corroded by oxygen and water vapor in the air, a passivation layer 915 is added in Fig. 9C on the basis of Fig. 9B, wherein the material of the passivation layer in the present embodiment can be SiO₂, the thickness of the passivation layer 915 is H912, and range of H912 is 0.01µm to 0.1µm.

In order to further improve the dispersion curve of the resonator near the series resonance frequency and prevent the oxygen element in the silicon dioxide passivation layer from diffusing to the top electrode layer, a passivation layer is added in Fig. 9D on the basis of Fig. 9B, and at the same time, another layer of metal electrode material 926 is added between the passivation layer and the top electrode. In the present embodiment, this layer of metal material can be chromium (Cr), the thickness of the metal layer 926 is H922, and the range of H922 is 0.04µm to 0.24µm.

Fig. 10A is a schematic section view of a bulk acoustic wave resonator according to an exemplary embodiment of the present invention. As shown in Fig. 10A, the bulk acoustic wave resonator includes a substrate 1000, and an air cavity 1001 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 1000A further includes a bottom electrode 1002, a piezoelectric layer 1003 and a top electrode 1004. The two ends of the bottom electrode 1002 extend beyond the range of the air cavity 1001 in two opposite directions, so that the two ends of the trapezoidal lower bottom edge of 1002 are partially in contact with the upper surface of the substrate 1000.

The piezoelectric layer 1003 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 1004 completely falls within the range of the first step of the piezoelectric layer in the section view, and the top electrode has an axisymmetric detail structure at its two ends 1005 at the same time.

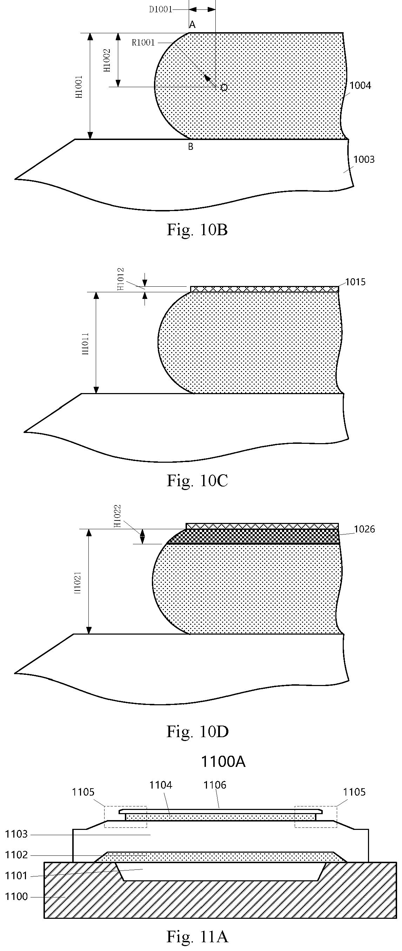

Fig. 10B is an enlarged view of a detail part 1005 in Fig. 10A. The top electrode 1004 is made of Mo in the present embodiment and has a thickness H1001, and the range of H1001 is 0.1µm to 0.6µm. A circular arc AB has a radius R1001, and the range of R1001 is 0.3µm to 20µm. In addition, the horizontal distance between the circle center O and an upper end pointAis D1001, the vertical distance is H1002, the range of D1001 is 0µm to 10µm, and the range of H1002 is 0µm to 0.6µm.

It should be pointed out that the AB segment can be a circular arc or other smooth protruding shapes.

In order to prevent the top electrode from being corroded by oxygen and water vapor in the air, a passivation layer 1015 is added in Fig. 10C on the basis of Fig. 10B, wherein the material of the passivation layer in the present embodiment can be SiO₂, the thickness of the passivation layer 1015 is H1012, and range of H1012 is 0.01µm to 0.1µm.

In order to further improve the dispersion curve of the resonator near the series resonance frequency and prevent the oxygen element in the silicon dioxide passivation layer from diffusing to the top electrode layer, a passivation layer is added in Fig. 10D on the basis of Fig. 10B, and at the same time, another layer of metal electrode material 1026 is added between the passivation layer and the top electrode. In the present embodiment, this layer of metal material can be chromium (Cr), the thickness of the metal layer 1026 is H1022, and the range of H1022 is 0.04µm to 0.24µm.

In the present invention, the structure shown in Fig. 9B is a typical suspension wing structure. The detail structure in the above-mentioned embodiment can also be arranged on the suspension wing structure.

In the present invention, optionally, at least a part of at least one of the upper and lower surfaces of at least one end of the top electrode is an inclined surface.

In the present invention, optionally, at least one of the upper and lower surfaces of at least one end of the top electrode includes: an inclined surface, and a vertical extension surface and/or a horizontal extension surface. The vertical extension surface here can be, for example, the AB surface in Fig. 6B, and the horizontal extension surface can be, for example, the CD surface in Fig. 6B.

In the present invention, for the inclined surface or the inclined extension surface, the length range in the horizontal direction is 0.02µm to 3µm, for example, 0.02µm, 2µm, or 3µm. The length can be used for determining the bandwidth range of a repressible parasitic mode.

Fig. 11A is a schematic section view of a bulk acoustic wave resonator according to an exemplary embodiment of the present invention. As shown in Fig. 11A, the bulk acoustic wave resonator includes a substrate 1100, and an air cavity 1101 embedded in the substrate functions as an acoustic mirror. The air cavity herein is only a specific embodiment of the acoustic mirror structure, and it is also applicable that the air cavity is replaced with other acoustic mirror structures including a Bragg reflecting layer.

The bulk acoustic wave resonator 1100A further includes a bottom electrode 1102, a piezoelectric layer 1103 and a top electrode 1104. The two ends of the bottom electrode 1102 extend beyond the range of the air cavity 1101 in two opposite directions, so that the two ends of the trapezoidal lower bottom edge of 1102 are partially in contact with the upper surface of the substrate 1100.

The piezoelectric layer 1103 has a stepped structure, which is composed of a first step, a second step and an interface between the two steps, wherein the plane of the first step is higher than the plane of the second step. The first step and the interface form the first edge of the piezoelectric layer; and the second step and the interface form the second edge of the piezoelectric layer.

The main part of the top electrode 1104 completely falls within the range of the first step of the piezoelectric layer in the section view, and the top electrode has an axisymmetric detail structure at its two ends 1105 at the same time.

The upper part of the top electrode 1104 is covered with a passivation layer 1106. In the present embodiment, the material of 1106 is aluminum nitride (A1N). Furthermore, the end face of 1106 is located on the outer side of the end face of 1104.

Fig. 11B is an enlarged view of a detail part 1105 in Fig. 11A. In the present embodiment, the top electrode 1104 adopts a traditional structure, and the passivation layer 1106 adopts the structure of solution (1). The solution combination in the present embodiment is only an exemplary embodiment, and is not used to limit the use possibilities of the other solution combinations involved in the specification. The thickness of the electrode 1104 is H1101, and the range of H1101 is 0.1µm to 0.6µm. The thickness H1102 of the passivation layer 1106 is 0.04µm to 0.24µm. The range of the height H1103 of an inclined edge AB is 0µm to 0.24µm. The range of the included angle α 1101 formed by the edge AB and the horizontal direction is 15° to 75°. The distance of the passivation layer 1106 extending to the outer side of the electrode 1104 in the horizontal direction is D1101, and the range of D1101 is 0.1µm to 3µm.

It should be pointed out that the detail structures shown in Figs. 1A-10D can also be applied to the embodiments in Fig. 11A and Fig. 11B.

In the present invention, in addition to the endpoint value, the mentioned numerical range can also be a median value between the endpoint values or other values, and all of which fall within the protection scope of the present invention.

Based on the above descriptions, the embodiment of the present invention proposes a bulk acoustic wave resonator, including: a substrate; an acoustic mirror; a bottom electrode arranged above the substrate; a top electrode opposed to the bottom electrode; and a piezoelectric layer arranged above the bottom electrode and between the bottom electrode and the top electrode, wherein at least one of the two ends of the top electrode is provided with a transverse mode vibration suppression structure.

Since the acoustic wave mode and intensity are closely related to the boundary conditions of the acoustic structure, based on this, the present invention proposes that at least one of the two ends of the top electrode is provided with the transverse mode vibration suppression structure.

The transverse mode vibration suppression structure can be a non-parallel structure of upper and lower surfaces arranged at the end part of the top electrode. Further, the non-parallel structure of upper and lower surfaces can be an inclined surface chamfer structure. On one hand, the inclined surface chamfer structure introduces an obtuse angle structure into the cross section geometry structure, thereby being conducive to preventing the parasitic mode from forming standing waves. On the other hand, the inclined surface chamfer structure is a continuously changing structure in space, which can suppress the parasitic mode within a wider bandwidth range compared with the traditional parallel structure, and at the same time, the bandwidth range can be adjusted according to the shape and size of the continuously changing structure. The transverse mode vibration suppression structure can also be a non-vertical surface that is arranged at the end face of at least one end of the top electrode and is different from a vertical surface, such as a concave surface or a convex surface, and this is also conducive to preventing the parasitic mode from forming standing waves.

The materials of the components of the bulk acoustic wave resonator according to the present invention will be illustrated below exemplarily and simply.

In the present invention, the material of the substrate includes, but not limited to: monocrystalline silicon (Si), gallium arsenide (GaAs), sapphire, quartz, or the like. The electrode materials used in the present invention can include, but not limited to: molybdenum (Mo), chromium (Cr), gold (Au), tungsten (W), aluminum (Al), platinum (Pt), ruthenium (Ru), etc.

In the present invention, the passivation layer is made of dielectric material, and the dielectric material can be selected from, but not limited to: silicon dioxide (SiO₂), silicon nitride (Si₃N₄), silicon carbide (SiC), aluminum nitride (AlN), aluminum oxide (Al₂O₃) and so on.

In addition, the material adopted by the acoustic mirror in the form of the Bragg reflecting layer in the present invention includes, but not limited to: molybdenum (Mo), aluminum nitride (A1N), tungsten (W), silicon dioxide, and the like. In addition, the hollow cavity type acoustic mirror adopted in the present invention can also be filled with a dielectric material, wherein the specific material can include, but not limited to: silicon oxide (silicon oxide), silicon nitride (silicon nitride), silicon carbide (silicon carbide) and other suitable dielectric materials. In a specific embodiment, the dielectric layer is made of a "dielectric material with a low dielectric constant" such as porous silica (porous silica), fluorinated amorphous carbon (fluorinated amorphous carbon), fluoro-polymer (fluoro-polymer), parylene (parylene), polyarylene ether (polyarylene ether), hydrogen silsesquioxane (HSQ), cross-linked polyphenylene polymer (SiLK), diphenylcyclobutene (BCB), fluorinated silicon dioxide (fluorinated silicon dioxide), carbon dopedoxide (carbon dopedoxide) or diamond like carbon (diamond like carbon). In the present invention, the "dielectric material with the low dielectric constant" refers to a dielectric material with a dielectric constant less than that of silicon dioxide.

The material of the piezoelectric film adopted in the present invention includes, but not limited to: aluminum nitride (A1N), zinc oxide (ZnO), and doped aluminum nitride (A1RN) with a certain atomic ratio, wherein the doping element R includes, but not limited to: scandium (Sc), magnesium (Mg), titanium (Ti), etc.

In order to reinforce and protect the convex bridge structure in the present invention, a passivation layer of a certain thickness can be added to a part of upper surface of the top electrode, and the optional material of the cover layer can include dielectric materials such as silicon dioxide and silicon nitride.

The embodiment of the present invention further relates to a filter, including the above-mentioned bulk acoustic wave resonator.

The embodiment of the present invention further relates to an electronic device, including the above-mentioned filter. It should be pointed out that the electronic device here includes, but not limited to, intermediate products such as radio frequency front-ends, filter amplifier modules, and terminal products such as mobile phones, WIFI, and unmanned aerial vehicles.

Although the embodiments of the present invention have been shown and described, those of ordinary skill in the art can understood that these embodiments can be changed without departing from the principle and spirit of the present invention, and the scope of the present invention is defined by the appended claims and their equivalents.

## Claims

1. A bulk acoustic wave resonator, comprising:
a substrate;
an acoustic mirror;
a bottom electrode arranged above the substrate;
a top electrode opposed to the bottom electrode; and
a piezoelectric layer arranged above the bottom electrode and between the bottom electrode and the top electrode,
wherein:
at least one of the two ends of the top electrode is provided with a transverse mode vibration suppression structure.

2. The resonator according to claim 1, wherein:
the suppression structure comprises a non-parallel structure of upper and lower surfaces arranged on at least one of the two ends of the top electrode.

3. The resonator according to claim 2, wherein:
at least a part of at least one of the upper and lower surfaces of at least one end of the top electrode is an inclined surface.

4. The resonator according to claim 3, wherein:
the angle formed by the inclined surface and the surface of the substrate is 15-75 degrees.

5. The resonator according to claim 4, wherein:
the length of the inclined surface in the horizontal direction ranges from 0.02µm to 3µm.

6. The resonator according to claim 3, wherein:
at least one of the upper and lower surfaces of at least one end of the top electrode comprises:
a vertical extension surface and/or a horizontal extension surface; and
the inclined surface.

7. The resonator according to claim 1 or 2, wherein:
the suppression structure comprises a non-vertical surface that is arranged at the end face of at least one end of the top electrode and is different from a vertical surface, wherein the vertical surface is perpendicular to the surface of the substrate.

8. The resonator according to claim 7, wherein:
the non-vertical surface has a shape of a concave surface or a convex surface.

9. The resonator according to any one of claims 1-8, further comprising:
a passivation layer arranged on the top electrode.

10. The resonator according to claim 9, wherein:
the thickness of the passivation layer is 0.01µm to 0.1µm.

11. The resonator according to any one of claims 1-8, further comprising:
a metal electrode material layer and a passivation layer, which are sequentially arranged on the top electrode.

12. The resonator according to claim 11, wherein:
the thickness of the metal electrode material layer is 0.04µm to 0.24µm.

13. The resonator according to any one of claims 1-12, wherein:
at least one end part of the top electrode comprises a suspension wing structure, and the suspension wing structure comprises the suppression structure.

14. The resonator according to any one of claims 1-13, wherein:
the two ends of the top electrode are axisymmetric structures to each other.

15. The resonator according to claim 1, further comprising:
a passivation layer, and the passivation layer is disposed to cover the top electrode,
wherein:
at least one end of the passivation layer extends beyond the corresponding end of the top electrode; and
the end of the passivation layer extending beyond the corresponding end of the top electrode is provided with the suppression structure.

16. The resonator according to claim 15, wherein:
the suppression structure includes a non-parallel structure of upper and lower surfaces of the passivation layer; and/or
the suppression structure comprises a non-vertical structure that is arranged at the end face of at least one end of the passivation layer and is different from the vertical surface, wherein the vertical surface is perpendicular to the surface of the substrate.

17. The resonator according to claim 15 or 16, wherein:
the two ends of the passivation layer extend beyond the corresponding end parts of the top electrode and are axisymmetric structures to each other.

18. The resonator according to claim 15, wherein:
the distance of the end part of the passivation layer extending beyond the top electrode is 0.1µm to 3µm.

19. The resonator according to claim 15, wherein:
the thickness of the passivation layer is 0.04µm to 0.24µm.

20. A filter, comprising the bulk acoustic wave resonator according to any one of claims 1-19.

21. An electronic device, comprising the filter according to claim 20.
